# EUROPEAN PATENT APPLICATION

(11) **EP 2 830 320 A1**
(43) Date of publication of application: **28.01.2015**
(21) Application number: 13177954.8
(22) Date of filing: 25.07.2013
(51) Int. Cl.: H04N 21/418, H05K 5/02, G06K 7/00, G06K 19/077

(54) **A USB conditional access module comprising a chip card reader and an adaptor**

(71) Applicant: SmarDTV S.A., 1033 Cheseaux-sur-Lausanne (CH)
(72) Inventor: Soulier, Julien, 13705 La Ciotat (FR); Munier, Jean-Christophe, 83740 La Cadière d'Ayzur (FR)
(74) Representative: Leman Consulting S.A.

(57) **Abstract**

The present invention relates to a conditional access module, a conditional access module dongle and a converter connector or an adaptor for connecting the conditional access module dongle to a host device. Different embodiments of the adaptor allow for the dongle to be connected to host devices having different types of connecting sockets such as PCMCIA or USB.

## Description

### TECHNICAL DOMAIN

The present invention relates to a conditional access module, a conditional access module (CAM) dongle and a converter connector or an adaptor for connecting the conditional access module dongle to a host device. Different embodiments of the adaptor allow for the conditional access module dongle to be connected to host devices having different types of connecting sockets such as PCMCIA, USB or HDMI.

### STATE OF THE ART

A conditional access module (CAM) is known in the state of the art as being a removable module which can be plugged into a host device, such as a digital TV, set-top box or other receiver/decoder, in order to provide capability for decrypting encrypted digital media content. The CAM is a secure device and may be realised in hardware or software or a mix of both. The DVB Common Interface (CI) specification allows for a television receiver or set top box (a host device) to interact with a secure hardware (or software or hardware/software) module (the CAM), thereby allowing the host device to decrypt access-controlled content. The CI specification defines an interface between the host and the CAM, so that the two will work together if both conform to the CI specification. This interoperability confers significant benefits on the CI system, as, in principle, it allows consumers a choice of compatible products from different manufacturers.

Conditional access modules (CAM) known in the state of the art may also have other functions. Thanks to the Common Interface a CAM may also be used to provide alternative connectivity and compatibility. For instance, an offline television that is capable of only receiving terrestrial broadcasts can run an application similar to an Internet Protocol Television (IPTV) if it has a CI input and a CAM with internet connectivity and TCP/IP compatibility. Such use is described in United States Patent Application Publication number 6,045,851 A1 and also in International Patent Application Publication number 2012/29018 A1.

European Patent Application Publication number 1,331,601 B1 describes a known chip card reader adhering to a so-called PCMCIA format. The PCMCIA format defines a standard format and form factor for Common Interface compatible devices such as Common Interface (CI or CI+) Conditional Access Modules (CAM or CICAM). Chip card readers such as the one disclosed in the mentioned publication are commonly used in conditional access modules (CAM) as they allow a convenient way to provide the CAM access to a security module. A security module is a required element in a CAM. Thanks to the CAM having a chip card reader, the security module can be housed on a chip card, therefore allowing for this secure element to be disconnected and kept separately from the main part of the module. This means that conditional access modules (CAM) for use with a Common Interface (CI or CI+) are required to adhere to this PCMCIA format. The chip card reader may be configured to read a chip housed on a smartcard or it may be configured to read a chip on a SIM card. It is generally expected that this standard format and form factor for chip card readers in use today will change in the near future. It is thought that the new form factor will be smaller than PCMCIA and probably will include a USB connector instead of the existing PCMCIA connector for connecting to the host device. Indeed, it may resemble a USB stick. This means that in the future a conditional access module (or CAM) will need to have a format which allows it to be used with a USB interface.

In keeping with this change, host device manufacturers will begin to manufacture devices, such as TVs for example, having a Universal Serial Bus (USB) socket for a conditional access module for example. On the other hand they may prefer to have a High Definition Multimedia Interface (HDMI). By USB it is meant any of the physical connections generally in use for allowing performance the USB communication standard, including USB, mini-USB and micro-USB. Similarly, by HDMI it is meant any of the known HDMI connections as long as it is configured to perform to the HDMI communication standard, including HDMI, mini-HDMI and micro-HDMI.

CAM manufacturers wishing to provide CAMs in one of the new formats (USB CAM or HDMI CAM for example), seeking to maintain the possibility of removing the secure element (the security module described above), will therefore be required to come up with innovative solutions as to how to include a SIM card reader or a Smartcard reader in the new CAM, these two formats being the generally accepted formats for removable secure elements in the CAM domain.

During a certain amount of time while the changeover from the PCMCIA format CAM to the USB or HDMI format CAM is underway, new host devices will be on the market having the new standard of socket (USB or HDMI for example), while existing host devices will still be in use having the old CI or CI+ (PCMCIA format) standard socket. This creates a problem for Pay-TV operators who have to supply conditional access modules to their customers to allow the customers to decrypt their content: which format should they use? The operator would have to plan to stock sufficient volume of USB-type CAMs and sufficient volume of traditional (PCMCIA or Common Interface) CAMs. The functionality of each of the types of CAM will be the same; it is just the interface which would have to be different. The problem is also felt by manufacturers of the conditional access modules, who have to supply modules conforming to the old format and to the new format. This can create inventory problems and the subsequent capital and cash flow problems.

United States Patent Application Publication number 2004/0201952 A1 describes a PCMCIA card converter connector including a PC card having a PCMCIA connector for connecting to a Common Interface card reader of a host device. The other end of the card includes at least one USB socket and the card is configured to convert the USB formatted signals to PCMCIA formatted signals. This would allow a conditional access module having a USB plug to be connected to a host device having a PCMCIA (Common Interface) socket.

Taiwanese Patent Application TWM241733Y shows a similar apparatus to the one above. Again, such a device would provide for a USB CAM to be connected to a host device having a PCMCIA socket.

In order for a television (TV) or Set Top Box (STB) to be able to decode digital content that is encrypted, the Conditional Access Module (CAM) is plugged into the DVB Common Interface (CI) which is usually on the TV or STB. The digital program stream, known as a Transport Stream (TS), from a satellite, cable, terrestrial broadcast, network (internet) or storage device (CD) is received by the TV or STB and routed to come into the CAM and back out to the TV or STB again. If the system works with a smart card (SC), then this smart card plugs into the CAM. The CAM will then enable decrypting of the digital program contents. Note that the TS is a standard DVB data stream containing information about programming material, and also the audio/video data (either in the clear, i.e. no encryption, or in encrypted format) and related data such as teletext or program guide. The video data is usually either MPEG-2, H.264 or MPEG-4 compressed. Recognising that STB systems will come onto the market with USB interfaces, United Kingdom Patent Application Publication number GB 2,442,779 A discloses a method for connecting an accessory to this USB interface which will allow for a CAM to be used with the STB (or TV). This document however does not address all of the problems solved by the present invention since the document rather describes TV sets or STBs which are devoid of any hardware for providing connectivity specifically to a CAM. It is thought that by providing a simple USB interface for receiving a clear TS, the TV or STB can be manufactured cheaper, with the hardware necessary for processing encrypted content being deported outwith the STB/TV since this may be regarded as an optional feature. The accessory disclosed in this document has the further disadvantage that since so much of the decryption-enabling hardware is deported from the STB/TV, any external accessory adapted to perform those functions, connectable to the USB port, cannot receive enough power through the USB port to sustain the function to be achieved. For this reason it is disclosed that the accessory requires an external power supply.

### BRIEF SUMMARY OF THE INVENTION

Embodiments of the present invention provide for a CAM having a USB connector. The CAM comprises a dongle and an adaptor. Various embodiments of the invention described herein allow for the CAM of the invention to be connected to either a "legacy" digital TV or STB having a CI connector or to newer digital TVs or STBs having either a HDMI connector or a USB connector. According to a particular embodiment, the CAM may be of the standard PCMCIA format including the physical dimensions of said format.

As mentioned above, the CAM of the present invention comprises a USB CAM dongle. According to the particular embodiment concerned, the CAM may cooperate with a SIM card or a Smartcard, the SIM card or the Smartcard providing security within the functionality of the CAM, as is already well-known in the state of the art. Alternatively, according to other embodiments, the secure functionality may be included in the USB CAM Dongle itself without the need for cooperating with a separate Smartcard or SIM card, although this is somewhat rare.

According to a first aspect of the present invention a conditional access module (CAM) is provided, the CAM comprising a USB CAM dongle (chip card reader) and an adaptor. According to one embodiment the adaptor is for connecting the USB CAM to a USB socket of a host device. According to another embodiment the adaptor is for connecting the USB CAM to a Common Interface of a host device, the CAM having a format compatible with the PCMCIA format including its physical dimensions. This embodiment also comprises a module, preferably a hardware module or a combined hardware and software module for converting USB-compatible signals to CI-compatible signals. The mentioned converter module is housed within the CAM, preferably within the adaptor and in the form of an integrated circuit in order for the module to fit within the physical dimensions of the adaptor. According to different embodiments the CAM may be adapted to receive and read a Smartcard or to receive and read a SIM card. Provision is made for a conditional access module for providing secure access to conditional access digital media content, the conditional access module being connectable to a host device at least for rendering the conditional access digital media content, the conditional access module comprising:
a host interface plug, at a first end of the conditional access module, for connecting to a corresponding interface socket on the host device; and
a chip card reader configured to read a removable secure element in order to provide said secure access;
**characterised in that:**
the conditional access module further comprises an adaptor at least to receive the chip card reader; and
the chip card reader comprises, at a first end of the chip card reader, a plug of a first type;
said connectivity being provided whether the host device has a corresponding interface socket of either the first type or a second type different from the first type.

According to another aspect of the present invention, there is provided an adaptor for connecting a module to a host device. According to one embodiment the adaptor allows for the module to be connected to a host device having a PCMCIA slot with a Common Interface socket. Such an adaptor preferably comprises a converter module for converting USB-compatible signals to CI-compatible signals. According to another embodiment the adaptor allows for the module to be connected to a host device having a USB socket. By USB socket it is meant a standard sized USB socket, a mini USB socket or a micro-USB socket. This embodiment of the adaptor does not require a converter module as described above since USB-compatible signals are already available and can be therefore routed straight to the USB socket. According to different embodiments the adaptor may be configured to receive a Smartcard or to receive a SIM card.

According to yet another aspect of the present invention, provision is made for a chip card reader having a USB connector plug.

Given the fact that the Common Interface and the USB interface will coexist in the domain of Pay-TV content delivery (by "coexist" it means some sets will have a CI type interface while others will have a USB or HDMI or other interface newer than the CI type interface) and given that many different business models are in use by Pay-TV operators, leading to many different requirements regarding the use of SIM cards or Smartcards, the present invention allows for CAM manufacturers to provide a cost-effective solution for making CAMs available for all the different business models and implementation systems.

### BRIEF DESCRIPTION OF THE DRAWINGS

The present invention will be better understood thanks to the detailed description which follows and the accompanying drawings, which are given as nonlimiting examples of embodiments of the invention, namely:
Fig. 1, showing a CAM according to an embodiment of a first aspect of the present invention, the CAM comprising a USB CAM dongle (chip card reader) according to an embodiment of another aspect of the present invention cooperating with an adaptor according to an embodiment of yet another aspect of the present invention;
Fig. 2, showing a CAM according to another embodiment of the present invention;
Fig. 3, showing another view of the CAM of Fig. 2;
Fig. 4, showing a CAM according to yet another embodiment of the present invention;
Fig. 5, showing a view of the CAM of Fig. 4 where certain elements from within the CAM have been made apparent
Fig. 6, showing another view of the CAM of Fig. 4, where again certain elements from within the CAM have been made apparent;
Fig. 7, showing a CAM according to still another embodiment of the present invention;
Fig. 8, showing another view of the CAM of Fig. 7;
Fig. 9, showing a view of the CAM shown in Fig. 8, where at least part of the inside of the USB CAM dongle (another aspect of the present invention) has been made apparent;
Fig. 10, showing a view of the CAM the CAM of Fig. 7, wherein a smartcard has been inserted into an appropriate front opening in the CAM;
Fig. 11, showing another view of Fig. 10;
Fig. 12 shows a Dongle according to a yet further embodiment of the first aspect of the present invention;
Fig. 13, showing another view of the CAM shown in Fig. 12, where the at least part of the inside of the CAM has been made apparent;
Fig. 14, showing an embodiment of a USB CAM dongle according to another aspect of the present invention, in which the bottom cover has been removed thereby revealing elements within the dongle;
Fig. 15, showing the bottom cover of the USB CAM dongle of Fig. 14, wherein a SIM card can be seen;
Fig. 16, where the bottom cover of the USB CAM dongle of Fig. 14 shows a recess for holding a SIM card; and
Fig. 17, showing the top cover of the USB CAM dongle of Fig. 14.
Fig. 18, showing a CAM according to a yet still further embodiment of the first aspect of the present invention, the CAM having a smartcard inserted.
Fig. 19, showing the CAM and smartcard of Fig. 18 viewed from a different angle, thereby allowing the bottom cover of the adaptor to be seen.

### DETAILED DESCRIPTION

The present invention provides a solution to some of the problems which will become apparent when manufacturers of host devices such as television sets will provide new sockets complying with a standard such as USB or HDMI for receiving modules such as conditional access modules (CAM) instead of the present socket complying with the common interface standard, suitable for receiving a PCMCIA format card for the conditional access module. Indeed, once such host devices having the new sockets appear on the market, suppliers and manufacturers will be left with the problem of having to satisfy demand both for modules within a housing having a connector conforming to the old standard (i.e. a PCMCIA format card with a Common Interface) and for modules within a housing having a connector conforming to a new standard, such as USB or HDMI, since host devices having the old and the new sockets will be deployed concurrently in the market and/or user-base.

Additionally, depending on particular systems employed by Pay-TV operators, an operator who requires that a Smartcard cooperating with a CAM be used in systems employing the present-day Common Interface may continue to require that a Smartcard still be used even when the system employs a USB interface. On the other hand, some operators may need SIM card compatibility in their CAMs instead of Smartcard compatibility. It will therefore be required to maintain all of these options concurrently in order to satisfy all of the users' needs. Smartcards and SIM cards are two generally accepted means of providing removable security modules in the domain of conditional access. Removable security modules are also known as removable secure elements.

Modules such as conditional access modules are high-value products and therefore having to provide all possible types of devices capable of interfacing a particular type of CAM to the host device, whether it be the USB or HDMI type or the PCMCIA/CI type, in sufficient quantities would be wasteful in terms of cost. It is thought that host manufacturers may soon provide host devices with sockets for modules, such modules requiring to be compatible with the USB standard. For a pay-TV operator, who has to provide appropriate modules to allow his customers to access his content, to have to stock large quantities of types of modules would be wasteful since the modules have a high cost. A similar problem would be felt by manufacturers of such modules. Complications related to stock control for the various modules implied will further manifest themselves.

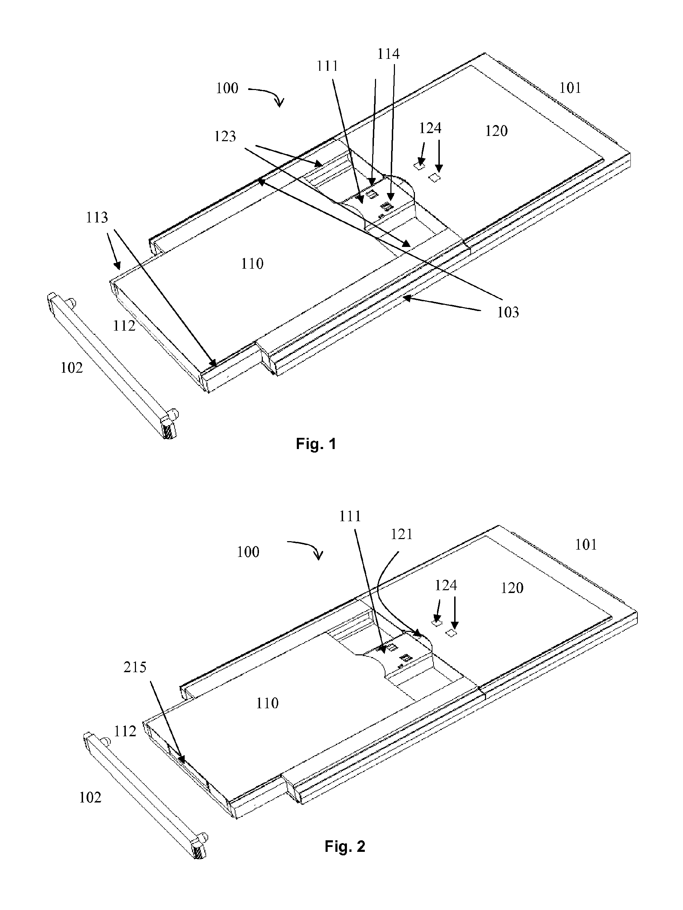

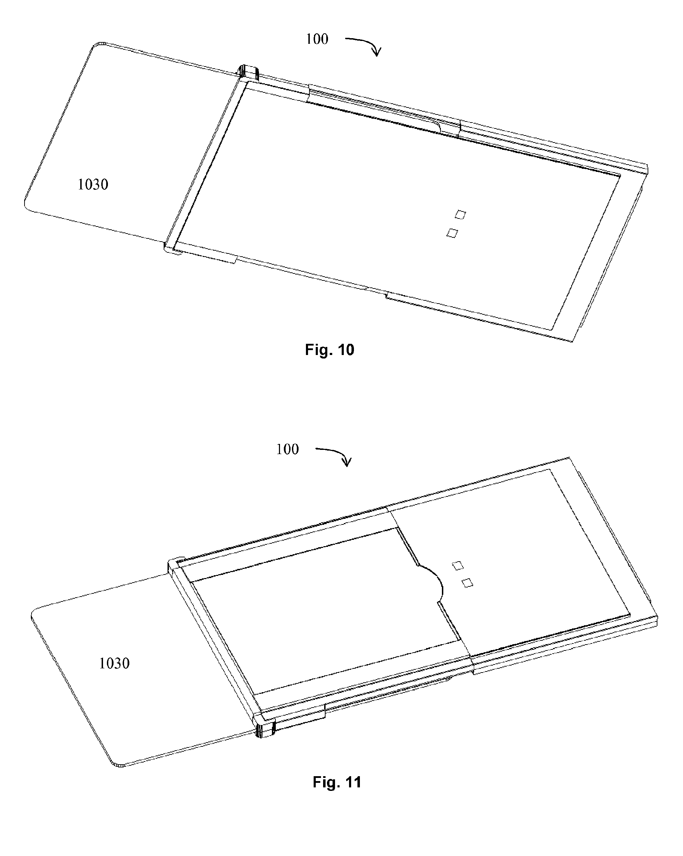

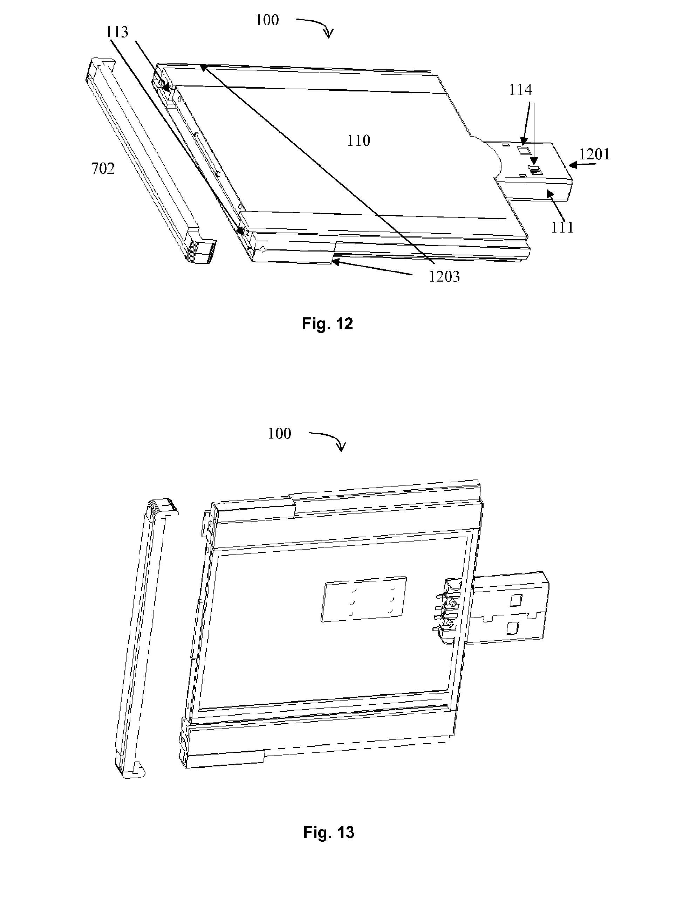

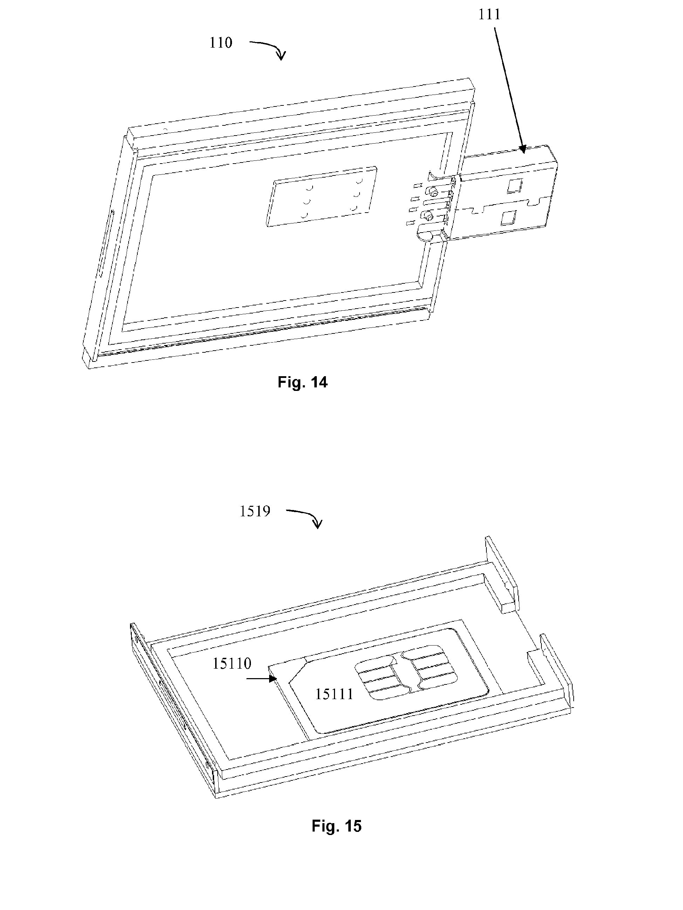

The present invention allows for a manufacturer of CAM modules, or an operator who has to provide CAM modules to his customers, to provide CAM modules presenting the appropriate form factor and connection plug for any of the available host devices whether they be configured to receive Common Interface (or CI+) modules or a new format such as USB or HDMI. Such CAM modules are illustrated in Figs 1, 2, 3, 4, 7, 10 and 11 as well as in Figs 12, 13, 18 and 19. The module comprises a USB CAM dongle and an adaptor. A USB CAM dongle is shown in Fig. 14. USB CAM dongles are also visible in Figs 1, 2, 4, 6, 7, 8, 9, 12 and 13. Adaptors can also be seen in Figs 1, 2, 4, 6, 7, 8, 9, 12 and 13. According to an aspect of the present invention, a USB CAM dongle is provided (110, 710) wherein the USB CAM dongle comprises a USB connector (111). This may be a standard USB connector, a mini USB connector or a micro USB connector, as long as it provides connectivity to a USB socket of a host device with which it is to cooperate.

According to another aspect of the present invention and one embodiment thereof, there is provided an adaptor to allow the dongle described above to be connected to a host device adapted to receive a Common Interface compatible module of the PCMCIA format. This is illustrated in Figs 1, 2, 4, 6, 7, 8, and 9. According to another embodiment thereof, there is provided an adaptor to allow the module described above to be connected to a host device adapted to receive a module having a USB interface. This is illustrated in Figs 12 and 13.

The adaptors according to the present invention are of low cost compared to the USB CAM dongles. Stocking of sufficient quantities each of the different embodiments of the adaptor in order to cover expected customer demand therefore is not a problem from a cost point of view or from a planning point of view. Only one type of dongle has to be stocked since, when deployed within the CAM according to embodiments of the present invention, it is compatible with hosts having Common Interface or CI+ connectors or other connectors such as USB or HDMI. Since this is where the bulk of the cost lies, less waste ensues.

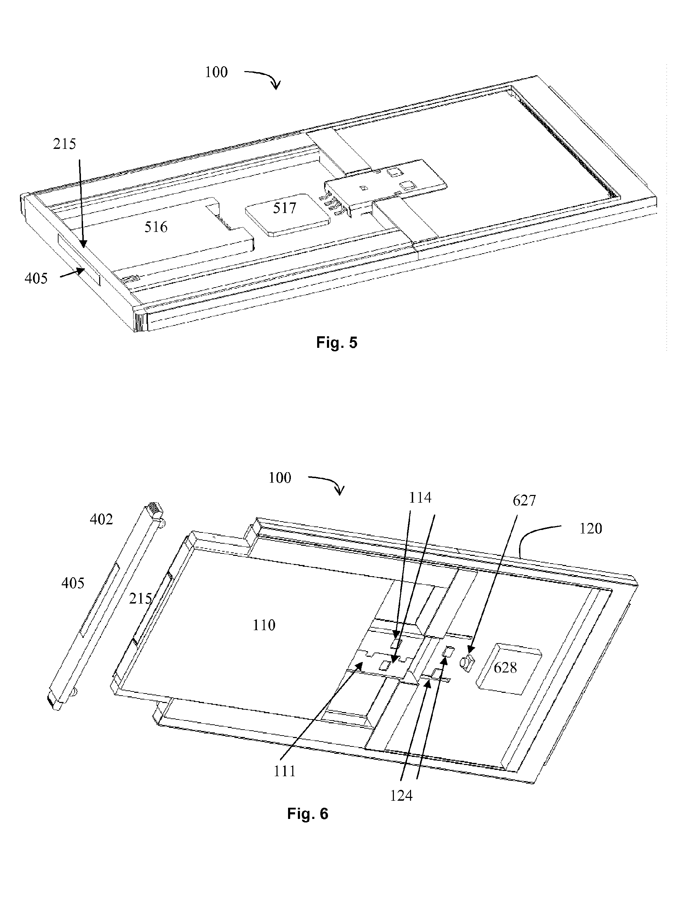

Adaptors according to the embodiments of the present invention illustrated in Figs. 1 through 11 require to be fitted with an electronic circuit configured to convert USB compatible signals to the Common Interface format. A small chip is useful for this, the chip comprising the necessary signal conversion function, which is simple to design and which may be manufactured cheaply. This does not add a lot to the cost of the adaptor. The aforementioned conversion circuit is preferably housed on a PCB board of the CAM in a convenient part of the adaptor, such as a part lying between the part where the USB CAM dongle resides and the part which connects to the Common Interface. The adaptors of Figs. 12, 13, 18 and 19 do not require a chip or any other active circuitry specifically for conversion of the interface connections from one standard to another as the USB connections are simply wired to the corresponding part of the USB plug. One such conversion chip (628) can be seen in Fig. 6.

According to one embodiment, where the adaptor comprises USB to CI conversion, such as any of those represented in Figs. 1 through 11, a switch (627) may be comprised within the adaptor (120). The switch (627) is configured to provide a signal indicating the presence of a USB CAM dongle (110) within the CAM (100). For mechanical stability of the dongle when connected to the adaptor, spring clips may be provided on the adaptor, which cooperate with corresponding holes or recesses on the USB plug of the dongle. Alternatively the clips may be on the adaptor while the recesses are on the USB plug of the dongle. The recesses or clips (326, 124) may appear on either or both of the top face or the bottom face of the adaptor (120, 120). Spring clips (124) and recesses (114) are shown in Fig. 1 and can also be seen under corresponding numbers in Figs. 2 through 11.

According to other embodiments, any of the adaptors of the present invention may be configured to receive a memory card such as or an SD card or a mini SD card or a micro SD card allowing for a user to have storage space for recording content for example or for storing personal data such as identifiers or codes or personal preferences and/or settings or viewing history or any such information which is deemed to be non-secure. This SD card (or mini- or micro- SD card) may be over and above any SD card used as a security module.

The USB CAM dongle of the present invention must be small enough to allow it to fit completely within the outer dimensions of any of the adaptors of the present invention. This avoids mechanical problems caused by the module sticking out from the host device in an awkward manner where it may be prone to damage from someone passing by and brushing against it or otherwise coming too close to it. In the case of the PCMCIA compatible adaptor, the module preferably fits within the outer dimensions of the adaptor such that the CAM according to one embodiment of the present invention therefore fits properly into the reception channel (or slot) on the host device designed for this purpose. The CAM of the present invention, including the USB CAM dongle and the adaptor can be at least partially inserted, preferably completely inserted, into the host's card reader reception channel in the same way that a traditional conditional access module would fit. As is generally known in the state of the art, the CAM conforms to the PCMCIA specified dimensions. Guide rails (103, 1203) on the sides of the adaptor may be useful in guiding the CAM into the slot in the host.

According to another embodiment, where the adaptor is compatible with USB, an extension cable may be provided between the USB plug on the module and the socket on the host so that the module can be placed out of harm's way, on a table for example, and only the connector to the USB socket and part of the extension cable protrude from the host rather than having the entire module sticking out of the host. Instead of being inserted on a horizontal direction into the host device, as is often the case for PCMCIA format modules, the CAM may be inserted in a vertical direction into the host, preferably in a downward direction. This relieves some of the mechanical forces which would present disadvantageous characteristics should a USB compatible module be inserted in the horizontal direction into the host device.

Embodiments of the present invention exist where, instead of a USB plug being provided, a HDMI plug or a FireWire plug or a SATA plug or a PCI plug is provided in order to be compliant should the new standard for host devices be any of those standards.

From a mechanical point of view, in order to provide adequate strength of the connection, the adaptor can be locked into the reader when it is being used and released during an ejection procedure when the module is to be no longer used.

Power to the CAM is provided from the host device and arrives through the interface (101, 1201) between the host and the CAM. According to the Common Interface specification, a host device should be able to supply up to 1.5W of power to a Common Interface module. On the other hand, according to the USB specification, a host device should be able to supply up to 2.5W of power to an attached module. According to embodiments of the present invention, the USB CAM dongle (which comprises the bulk of the conditional access module functionality) is configured to provide all essential conditional access features while drawing from its host no more than the specified maximum power of a Common Interface i.e. 1.5W. In this manner, all essential features for which a CAM is intended can be accomplished whether the USB CAM dongle is co-operating with either a USB adaptor or a CI adaptor. According to an embodiment of the present invention, the USB CAM dongle is configured to detect whether it is connected to a USB host or a Common Interface host and to provide access to a mode of operation which may require more than the specified maximum power deliverable by a Common Interface and up to the specified maximum power deliverable by a USB interface. In this manner the CAM may take full advantage of being able to use more power whenever it is allowable. More features may then be accessible when the CAM is plugged into a USB host. The switch (627) present in the adaptor for connection to a Common Interface host may be used to provide information to the USB CAM dongle as to which type of adaptor is being used. This allows for a USB CAM dongle to detect whether it is connected to a USB host or a Common Interface host and to set its mode of operation accordingly.

Suppliers of CAMs, benefiting from the present invention, will manufacture only USB CAM dongles having any of a standard, a mini or a micro USB plug at a first end of the dongle and matching adaptors. The adaptor, according to the particular embodiment, has either a USB socket for cooperating with the USB plug of the dongle or is configured to allow the dongle's own USB plug to be inserted straight into a host's USB socket. The adaptor with the USB socket further comprises at one end a common interface plug for cooperating with a Common Interface on a host device. Similarly, operators need only buy one type of module (USB CAM dongle) and the two types of adaptors and then supply the appropriate type of adaptor to their clients depending on whether they have a host with a CI interface or a USB interface. The same module will be used for clients using the new standard of host interface and the old standard. A customer who buys the new module will only have to change adaptors when he changes his host from USB type to Common Interface type or vice versa. The CAM therefore has a host interface plug which can be a USB plug or a Common Interface plug depending on which adaptor is used. The CAM's host interface is therefore the adaptor's Common Interface plug in one case and the chip card reader's USB plug in the other case.

Thanks to various embodiments of the present invention, CAM manufacturers need not build several different types of CAM to satisfy the old market, where hosts had all Common Interfaces for CAMs, while at the same time satisfying the new market where hosts will have USB sockets for the CAM. The CAM manufacturer just needs to make USB CAM dongles according to the present invention and different types of adaptors: one for the Common Interface and one for the USB interface. The adaptors are cheap whereas the USB CAM dongle comprises the expensive element. It is therefore advantageous that the manufacturer only has to make one type of USB CAM dongle for all the embodiments of CAM of the present invention regardless of which embodiment of adaptor of the present invention is used.

The USB CAM dongle has a USB connector at one end. It may have a SIM card inside, preferably housed within a cover of the dongle, in a suitable recess, where contact to the SIM card is made through suitable connections on the PCB of the dongle. The dongle has two such covers, a top one and a bottom one, preferably one made from metal and the other made from plastic, both of which cooperate with a plastic frame which houses the PCB board of the dongle. According to embodiments of the present invention it is the top cover which is metal and the bottom cover plastic. The SIM card mentioned above may lodged in the plastic cover. Alternatively the dongle may be used without the plastic cover of the mentioned covers and the connections will be therefore available for making contact with a Smartcard suitably inserted into the CAM to be able to have the pads of its chip make contact with said connections. The dongle cooperates with an adaptor. The metal of the top cover is up 0.2mm thick in order to fit in the adaptor (0.18mm according to some embodiments). The covers latch at the front and back to the plastic frame, preferably in grooves. See Figs. 15, 16 and 17. The CAM, including the dongle and the adaptor, preferably has dimensions of around 66.5mm length, 39mm width and 5mm height in order to comply with the PCMCIA standard. The dongle itself preferably has a height of up to 4.8mm.

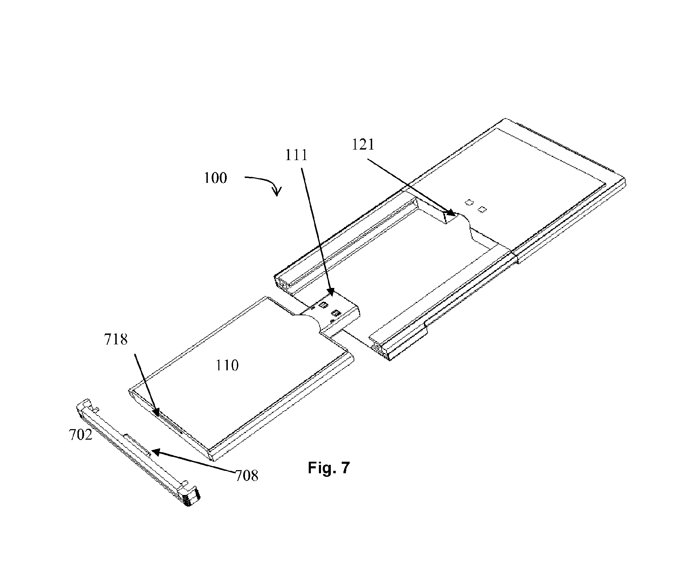

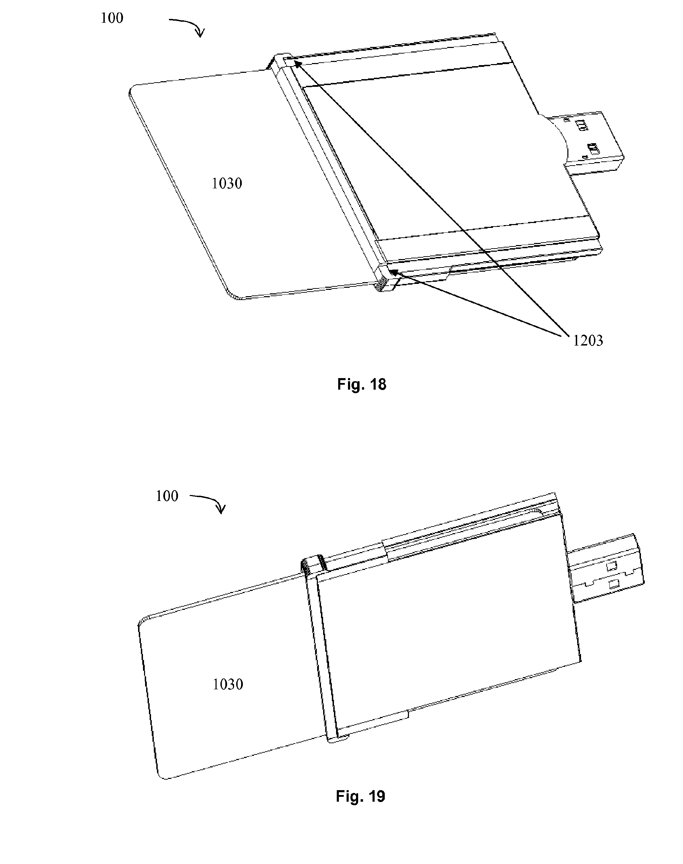

The adaptor has a metal top cover and a metal bottom cover at least over part of its length. The bottom cover may cover the full length of the adaptor (corresponding to the full length of the CAM as shown in Fig. 7 and in Fig. 19) while the top cover may cover only a part of the length of the adaptor. The covers are made of metal to provide electromagnetic shielding to the electronics within and to allow the CAM to comply with the maximum required thickness according to the PCMCIA format. When the top cover of the adaptor only covers part of the length of the CAM (adaptor) the shielding effect is complemented by the top cover of the dongle when it is connected to the adaptor (see Fig. 7). A PC-Card Type II complying with this standard has to be 100mm long by 55.2mm wide by 5mm thick. This means that the CAM has to comply with this standard. Since the dongle can have a thickness of up to 4.8mm, this dictates the maximum thickness of the metal bottom case of the adaptor since the thickness of the adaptor and the dongle together has to be within the 5mm specified limit. The metal case of the adaptor therefore has to be a maximum of 0.2mm thick. See Fig. 7: with a bottom case of the adaptor of up to 0.2mm thick and the height of the dongle being 4.8mm maximum, the maximum thickness of the CAM is respected. The adaptor further comprises two plastic spacers on either side, the spacers also functioning as sliders to guide the USB CAM, which can be slid in from the front end before being held and locked in from the front by a plastic end-cover which forms another part of the adaptor.

According to the present invention, the dongle, being the cost-intensive part of the CAM, is the same for all different embodiments. The dongle has a maximum height of about 4.8mm. This leaves up to 0.2mm for the thickness of the metal bottom cover of the adaptor. When the CAM is to be used with a smartcard, the front cover of the adaptor is configured with an opening for receiving the smartcard. The front part of the extension region (see later) of the CAM (and therefore of the adaptor) has a set of lateral guides to guide the card through the CAM. The card is therefore guided by the lateral guides and the bottom cover of the adaptor. The dongle is used without its plastic bottom cover. Since the bottom cover of the adaptor has a thickness which is approximately the height of a standard smartcard this leaves enough space for the smartcard to slide between the dongle and the bottom cover of the adaptor. When the CAM is to be used with a SIM card, the SIM card may lie in a recess in the bottom cover of the dongle; the dongle is used with its bottom cover in place and so the SIM card can connect with the pads on the card reader on the PCB board of the dongle in the same way as the contacts of the Smartcard's chip would have been contacted. The CAM can also be used with a SIM card slid through the front of the dongle when the front cover has a hole for the SIM card and the dongle has a corresponding recess for the SIM card reader. In this case the dongle is also used with the bottom cover thereby complying with the height requirement of the CAM.

According to one embodiment of adaptor, it comprises a socket to receive the USB CAM dongle's USB plug and it further comprises a spring clip in its metal cover to cooperate with the USB plug and snap into place. A switch on the PCB detects when the dongle is inserted into the adaptor. The back end of the adaptor has a connector for connecting to a host's Common Interface connector. The bottom case of the adaptor covers the entire length of the adaptor while the metal top case covers from the back end to the part where the dongle's USB plug fits into the adaptor's USB socket. In this way proper shielding is maintained at the bottom thanks to the bottom case of the adaptor and at the top thanks to a combination of the metal top case of the adaptor and the metal top case of the dongle.

According to another embodiment of the adaptor, the back end is left open so that the dongle's USB plug can cooperate with the USB socket of a host device. This adaptor has the plastic guides at the side as above and the plastic front end cover to lock the dongle in place. This embodiment has no converter circuit.

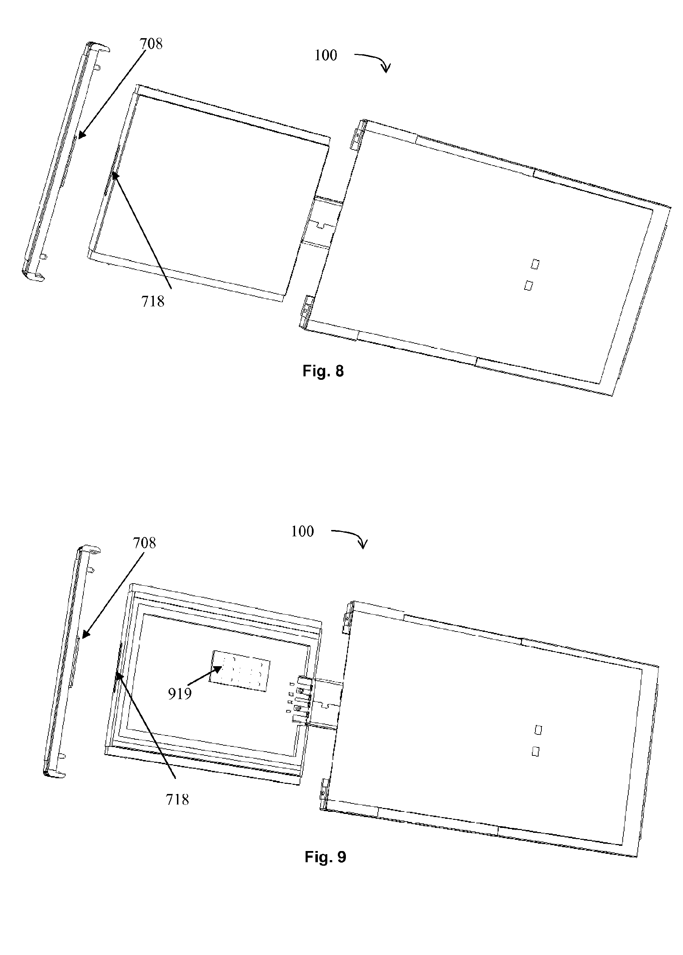

Different embodiments of the above two types of adaptor are made possible by the present invention. In one embodiment, where a Smartcard needs to be used as part of the conditional access system in use, the front end cover has an opening through which the Smartcard can enter. The Smartcard is guided into the CAM and under the PCB of the dongle, which is used without its bottom cover, so that the pads of the chip on the Smartcard can connect to the connections on the underside of the PCB of the dongle. The guiding is provided by two metal guides which go around the sides of the CAM housing. The guides are a continuation of the adaptor's bottom case, which are bent around and fit into the plastic spacers. These guides are slightly wider than the width of the CAM and are only at the front end. This way the edges of the Smartcard are flush with the edges of the module, which is open except for this area just at the front end. See Figs. 8, 9, 10, 11, 12, 13, 18 and 19. Embodiments of the CAM which are to be used with smartcards require that there be a front opening of adequate height to allow the smartcard to be introduced. The opening is formed between the bottom cover of the adaptor and the bottom face of the dongle. The dongle is used without its bottom cover so that contact may between the pads of the chip on smartcard and the corresponding pads on the chip card reader of the CAM (i.e. on the USB CAM dongle). In order to keep this opening open it is necessary to hold the bottom cover of the adaptor and the bottom face of the dongle apart in the z-direction (vertical direction in Fig. 7 for example). This is done by arranging for the front end cover (102) of the CAM (100) (also serving as a front end cover of the adaptor) to have a tongue (708) which cooperates with a corresponding groove (718) in the USB CAM dongle (110). Tongues and grooves for ensuring the presence of an opening suitable for the smartcard are also shown in Figs. 8, 9, 12, 13, and 14.

When a CAM is to be used with a smartcard, the thickness of the dongle needs to be less than 4.8mm. Indeed the thickness of the dongle needs to be such that when the dongle is held in its vertical (z) position by the tongue and groove configuration on the front cover of the adaptor and the dongle, enough space remains between the dongle and the bottom case of the adaptor to allow for the smartcard to be inserted.

Embodiments of adaptor which are not required to cooperate with a Smartcard have a simple end cover without the opening for a Smartcard and without the special metal guides requiring a wider front end and leaving a space where the edges of the Smartcard are flush with the edges of the CAM as described above. Instead this embodiment has a solid front cover and the width of the entire module may be constant. See Figs 1 to 6. Other embodiments may have the simple end cover but still keep the CAM dimensions of the embodiments suitable for use with Smartcards, with the wider front end or so-called extended region. Yet other embodiments may have the front cover suitable for use with a Smartcard: a Smartcard can then be used as described above i.e. without the bottom cover of the dongle; whenever a SIM card is to be used instead of the Smartcard the dongle is used with its bottom cover, the SIM card is placed in the bottom cover of the dongle and the extra height of the bottom cover compensates for the space which would have been left had the CAM been used with a Smartcard.

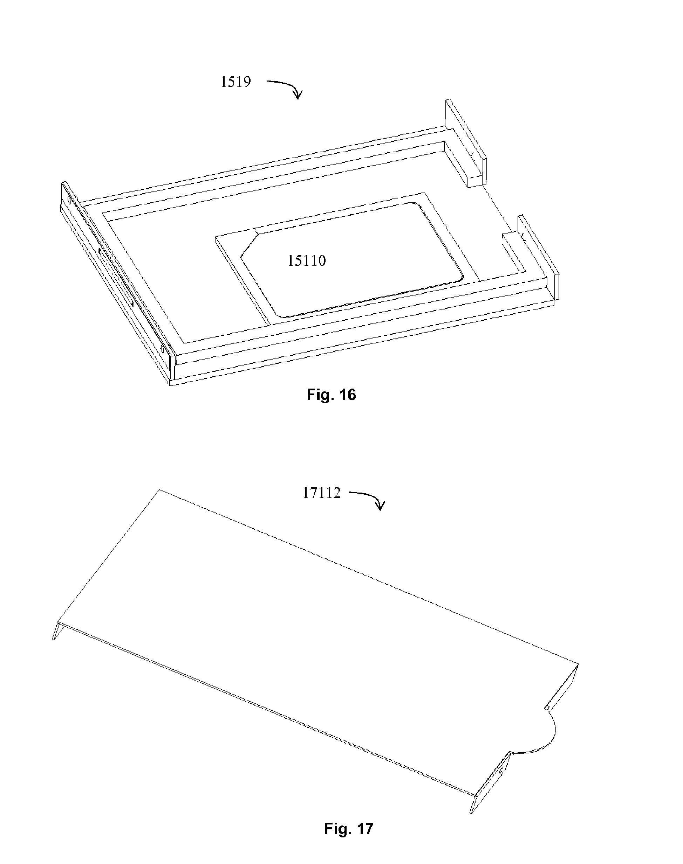

For embodiments which do not cooperate with smartcards, various configurations are possible and are shown in the drawings as follows: Fig.1 shows a CAM having a USB CAM dongle and an adaptor for connection to a host having a CI type of interface. The CAM is configured to work with a SIM card and the SIM card is housed in the bottom cover of the dongle. Fig. 15 shows a bottom cover of a dongle with a SIM card installed. Fig. 16 shows a recess in the bottom cover of a dongle for receiving a SIM card. Fig. 14 shows a dongle with its bottom cover removed so that the contacts for the SIM card are shown. The front cover of the CAM shown in Fig. 1, also functioning as a front cover of the dongle, serves to close the CAM and hold the dongle in place. It may be made from plastic and may be clipped or otherwise locked into place. The front cover in this embodiment does not need a tongue since no smartcard is to be used and it does not need any holes for receiving a SIM card since the SIM card is housed in the bottom case of the dongle.

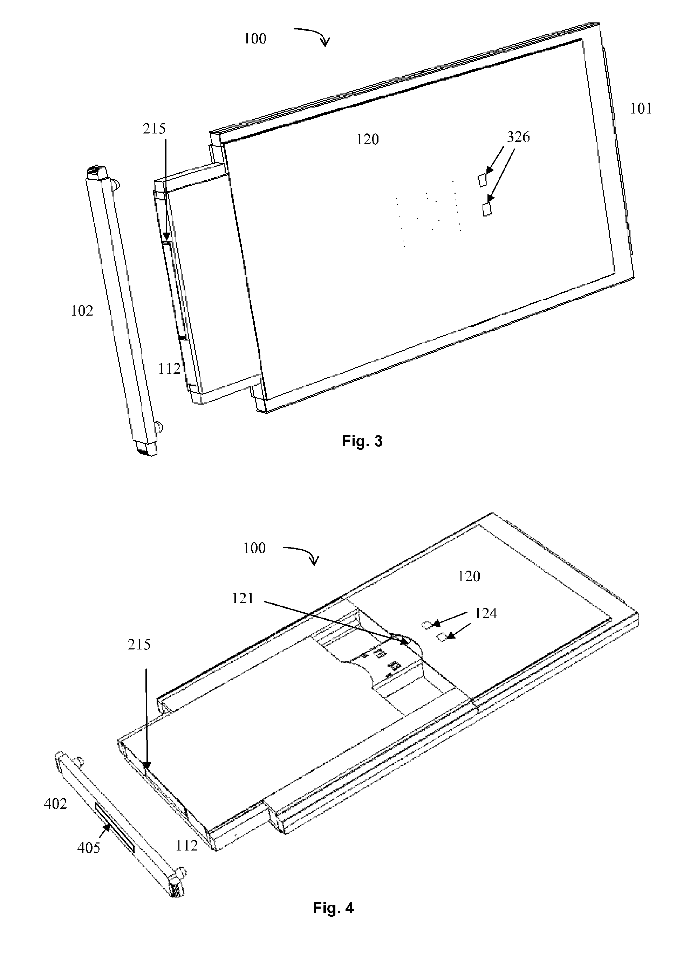

Fig. 2 is similar to Fig. 1 except that it has a hole at the front of the dongle for receiving a SIM card or an SD card. In this case it is not necessary for the dongle to be fitted with a SIM card in its bottom case since the SIM card is inserted into the front end of the dongle. On the other hand, both a SIM card and an SD card can be used, in which case one will be inserted into the front of the dongle while the other will be housed in the bottom case of the dongle. Fig. 3 shows another view of the CAM of Fig. 2.

Fig. 4 is similar to Fig. 2 in that it is adapted to receive a SIM card or SD card into the front end of the dongle. The difference in this case is that the front cover also comprises a hole corresponding to the hole in the dongle so that the SIM card or SD card can be inserted even after the CAM has been closed using the front cover. Figs. 5 and 6 show other views of this type of CAM.

Figs 7, 8, 9, 10, 11, 12, 13, 18 and 19 show CAMs which are adapted to receive smartcards and so have the tongue and groove configuration mentioned above. The front portion of these CAMs, known in the state of the art as the extended portion, may be wider than the smartcard and comprise guides to guide the smartcard into the CAM. The rest of the CAM is of the same width as the Smartcard and is devoid of guides such that the edges of the smartcard, when inserted, lie flush with the edges of the CAM. This necessary since the width of the slot in the host device, destined to receive the CAM is specified to have the same width as the smartcard. The extended portion may therefore extend outside of the slot when the CAM is in use.

Thanks to various embodiments of the present invention, Pay-TV operators who were using Smartcards to provide the secure component of their conditional access system will be able to continue using the Smartcard when the host device manufacturers change to USB interfaces instead of Common Interfaces, while still remaining compatible with the Common Interface. To this end, there is provided the USB CAM dongle of the present invention and one of the adaptors of the present invention. The adaptor which has an opening in its front end (between the dongle and the adaptor bottom cover) is used with a USB CAM dongle of the present invention, where the bottom plastic cover of the dongle is removed to allow contact to be made between the Smartcard's chip's pads to the dongle. According to different embodiments, the CAM thus described can be connected to a host with a USB socket, where the dongle's USB plug goes directly to the host's socket, or the CAM can be connected to a host having a Common Interface, where the adaptor further comprises a USB socket to receive the dongle's plug, a circuit for converting the USB signals to CI compatible signals and a CI connector at the back. Operators who do not need Smartcards to be used are also able to benefit from the present invention using the embodiment of the adaptor with a solid front end cover and a SIM card housed within the bottom cover of the dongle or with a hole in the front cover for receiving a SIM card.

Manufacturers of CAMs provide CAMs comprising a chip card reader (also described in all of the above embodiments of the present invention as a USB CAM dongle) and an adaptor. The dongle comprises a USB connector and can be used with a SIM card or with a Smartcard as removable secure element thanks to the different possibilities with or without the dongle's plastic bottom cover. The adaptor is cheap and may be of a type which converts the USB signals to Common Interface signals or of a type which does not convert the USB signals in which case the dongle's USB connector is connected directly to the host. Both adaptors may be made available with or without a slot (405) at the front end cover for receiving a SIM card. On the other hand, in order to reduce the number of different adaptors all of them could have the slot and the slot would remain unused whenever it was not necessary to read SIM cards. Similarly, in order to limit the number of different types of adaptors and chip card readers, the adaptor may always have a tongue (708) and the chip card reader (dongle) may always have a corresponding groove (718) so that whenever the conditional access module is to be used with a smartcard and the dongle therefore used without its bottom cover, the dongle is held properly in place in the z-plane so that enough space is available between the CAM bottom cover and the bottom of the chip card reader for the smartcard to be inserted. When the CAM is to be used with a SIM card, either housed in the chip card reader's bottom cover or inserted through a slot in the front end of the reader, then the presence of the tongue and groove, although no longer necessary for holding the dongle in the z-plane, does not interfere with the operation of the module. In this manner, manufacturers would only be required to make one type of chip card reader and two types of adaptor to allow their end users to have a conditional access module for either a host having a Common Interface or a host having a USB interface.

## Claims

**1.** A conditional access module (100) for providing secure access to conditional access digital media content, the conditional access module (100) being connectable to a host device at least for rendering the conditional access digital media content, the conditional access module (100) comprising:
a host interface plug (101, 1201), at a first end of the conditional access module, for connecting to a corresponding interface socket on the host device; and
a chip card reader (110) configured to read a removable secure element (1030, 15111) in order to provide said secure access;
**characterised in that:**
the conditional access module (100) further comprises an adaptor (120) at least to receive the chip card reader (110); and
the chip card reader comprises, at a first end of the chip card reader, a plug of a first type (111);
said connectivity being provided whether the host device has a corresponding interface socket of either the first type or a second type different from the first type.

**2.** The conditional access module (100) according to claim 1, wherein the removable secure element (15111) is a SIM Card, the chip card reader (110) further comprising:
a top cover (17112) comprising metal;
a SIM Card reader (919) having connections for reading the SIM Card (15111); and
a removable bottom cover (1519) comprising plastic, the bottom cover comprising a recess (15110) for the SIM Card (15111).

**3.** The conditional access module (100) according to claim 1, wherein the removable secure element is a SIM Card, the USB CAM further comprising:
a top cover (17112) comprising metal; and
a SIM Card reader (516) having connections for reading the SIM card, the SIM Card reader (516) being accessible via a slot (215) at a second end of the chip card reader (110) for receiving the SIM Card;

**4.** The conditional access module (110) according to claim 1, wherein the removable secure element is a SIM Card, the USB CAM further comprising:
a top cover (17112) comprising metal; and
a SIM card reader (516) having connections for reading the SIM card, the SIM Card reader (516) being accessible via a slot (215) at a second end of the chip card reader (110) for receiving the SIM Card;
the conditional access module further comprising a front cover (402) comprising a slot (405) corresponding to the slot (215) in the chip card reader (110), through which the SIM Card may be inserted.

**5.** The conditional access module (100) according to claim 1, wherein the removable secure element (1030) is a Smart Card having a first width, the conditional access module having at most the first width at the first end of the conditional access module and a second width, more than the first width, at a second end of the conditional access module, the conditional access module comprising a bottom case comprising metal, the chip card reader further comprising:
a top cover comprising metal; and
a Smart Card reader having connections for reading the Smart Card;
the conditional access module further comprising a front cover comprising:
a tongue cooperating with a corresponding groove in a second end of the chip card reader for holding the chip card reader within the conditional access module in a position which allows the Smart Card to be slid between the chip card reader and the bottom case of the conditional access module; and
a set of lateral guides at the second end of the chip card reader for guiding at least part of the Smart Card through the conditional access module.

**6.** The conditional access module (100) according to claim 5, wherein said host interface plug (1201) is the plug of the first type (111) comprised in the chip card reader (110).

**7.** The conditional access module (100) according to claim 5, wherein the adaptor (120) is further configured to convert a first plurality of signals from the plug of the first type (111) to a second plurality of signals, the adaptor (120) further comprising:
a socket of a first type (121) to receive the plug of the first type (111);
a plug of the second type at the first end of the conditional access module (100); and
a conversion module (628) to convert the signals of the first type to the signals of the second type and to route the signals of the second type to the plug of the second type;
said host interface plug (101) being the plug of the second type.

**8.** The conditional access module according to any of the preceding claims, wherein the plug of the first type (111) is a USB plug.

**9.** The conditional access module according to claim 7, wherein the plug of the first type (111) is a USB plug and the plug of the second type is a plug compliant to a Common Interface Standard.

**9.** The conditional access module according to any of the preceding claims, wherein it is configured to be inserted at least partially into a host device having a slot for receiving a Common Interface compliant conditional access module.

**10.** The conditional access module according to any of the preceding claims, wherein it is configured to provide electromagnetic shielding to the secure element.
